# EUROPEAN PATENT APPLICATION

(11) **EP 3 672 081 A1**
(43) Date of publication of application: **24.06.2020**
(21) Application number: 18215770.1
(22) Date of filing: 21.12.2018
(51) Int. Cl.: H03M 1/10, H03M 1/12, H03M 1/66

(54) **CALIBRATION OF CLOCK-CONTROLLED CIRCUITRY**

(71) Applicant: Socionext Inc., Yokohama-shi, Kanagawa 222-0033 (JP)
(72) Inventor: STANCHEV, Nikola Kirilov, Swindon, SN3 3RB (GB); ROYSTON, Philip Stewart, Maidenhead, Berkshire SL6 4FJ (GB)
(74) Representative: Haseltine Lake Kempner LLP

(57) **Abstract**

A method of performing performance tests to determine calibrated configurations for clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result.

## Description

The present invention relates to calibration of clock-controlled circuitry.

Such clock-controlled circuitry may comprise signal processing circuitry, which may operate based on clock signals of a multiphase clock signal. The calibration may relate to the calibration of variable elements such as variable impedances (which can adopt one of a set of configurations) connected to clock lines carrying the clock signals, and thus affect the operation of the signal processing circuitry. For example, the calibration of such elements may serve to control and/or compensate for clock skew between those clock signals.

The present invention thus extends to methods for performing performance tests to determine calibrated configurations for such clock-controlled circuitry, methods for calibrating the clock-controlled circuitry and corresponding circuitry and computer programs.

One possible application of such methods is in relation to the generation (e.g. in a voltage-controlled oscillator (VCO)) and supply of clock signals for time-interleaved analogue-to-digital converters (ADC) and time-interleaved digital-to-analogue converters (DAC).

By way of background, therefore, to explore merely one potential application of the method of the present invention, aspects of time-interleaved ADC circuitry disclosed in EP-A1-2211468 will now be considered.

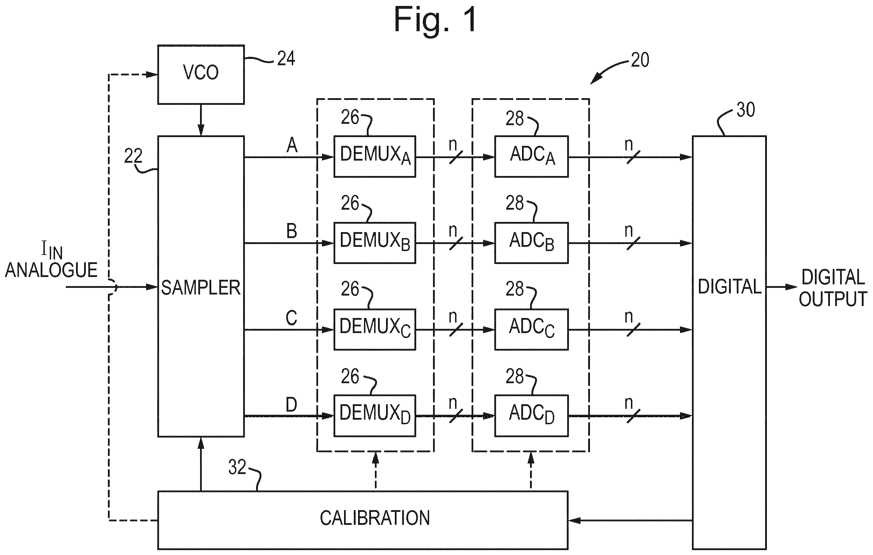

**Figure 1** is a schematic diagram of analogue-to digital-circuitry 20, to which the present invention may be applied. Circuitry 20 comprises sampler 22, voltage-controlled oscillator (VCO) 24, demultiplexers 26, ADC banks 28, digital unit 30 and calibration unit 32.

The sampler 22 is configured to perform four-way or four-phase time-interleaving so as to split the input current I_{IN} into four time-interleaved sample streams A to D. For this purpose, VCO 24 is a quadrature VCO operable to output four clock signals 90° out of phase with one another, for example as four raised cosine signals. VCO 24 may for example be a shared 14 GHz quadrature VCO to enable circuitry 20 to have an overall sample rate of 56 GS/s.

Each of streams A to D comprises a demultiplexer 26 and an ADC bank 28 connected together in series as shown in Figure 1. The sampler operates in the current mode and, accordingly, streams A to D are effectively four time-interleaved streams of current pulses originating from (and together making up) input current I_{IN}, each stream having a sample rate one quarter of the overall sample rate.

Focusing on stream A by way of example, the stream of current pulses is first demultiplexed by an n-way demultiplexer 26. Demultiplexer 26 is a current-steering demultiplexer and this performs a similar function to sampler 22, splitting stream A into n time-interleaved streams each having a sample rate equal to 1/4n of the overall sample rate. Continuing the example overall sample rate of 56 GS/s, the n output streams from demultiplexer 26 may each have a 14/n GS/s sample rate.

The n streams output from demultiplexer 26 pass into ADC bank 28, which contains n ADC sub-units each operable to convert its incoming pulse stream into digital signals, for example into 8-bit digital values. Accordingly, n digital streams pass from ADC bank 28 to digital unit 30. In the case of n=80, the conversion rate for the ADC sub-units may be 320 times slower than the overall sample rate (i.e. 80x4=320).

Streams B, C, and D operate analogously to stream A, and accordingly duplicate description is omitted. In the above case of n=80, circuitry 20 may be considered to comprise 320 ADC sub-units split between the four ADC banks 28.

The four sets of n digital streams are thus input to the digital unit 30 which multiplexes those streams to produce a single digital output signal representative of the analogue input signal, current I_{IN}. This notion of producing a single digital output may be true schematically, however in a practical implementation it may be preferable to output the digital output signals from the ADC banks in parallel.

Calibration unit 52 is connected to receive a signal or signals from the digital unit 50 and, based on that signal, to determine control signals to be applied to one or more of the sampler 22, VCO 24, demultiplexers 26 and ADC banks 28.

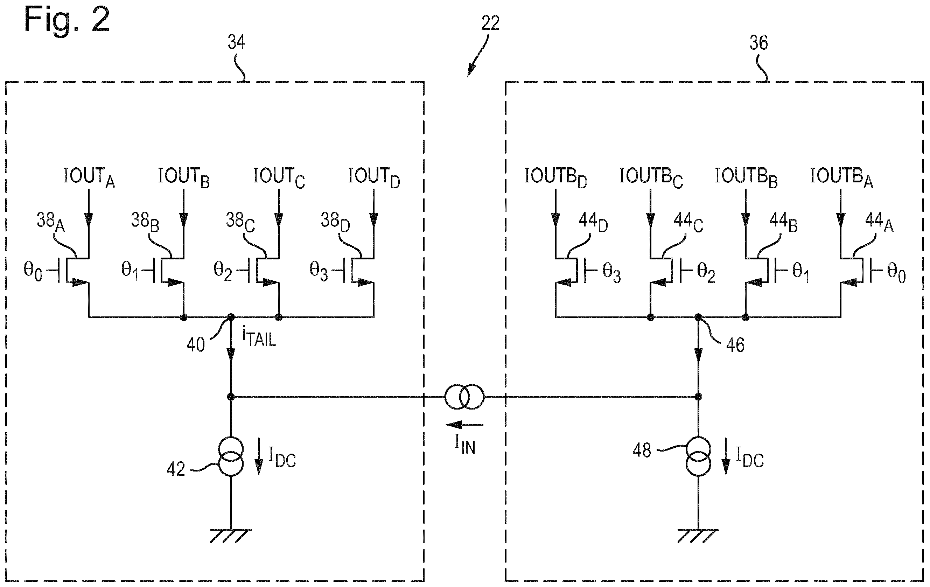

**Figure 2** is a schematic circuit diagram of four-phase (i.e. multiphase) current-mode (current-steering) sampler 22. Although in Figure 1 a single-ended input signal, current I_{IN}, is shown, it will be appreciated that a differential input signal could be employed, for example to take advantage of common-mode interference rejection. Accordingly, the sampler 22 and demultiplexers 26 and ADC banks 28 could be effectively duplicated in circuitry 20 to support such differential signalling, however such duplication is omitted from Figure 1 for simplicity. Returning to Figure 2, sampler 22 is configured to receive such a differential input current signal, modeled here as a current source I_{IN} whose magnitude varies with the input signal.

Because of the differential signalling, sampler 22 effectively has two matching (or corresponding or complementary) sections 34 and 36 for the two differential inputs. Accordingly, there is a first set of output streams IOUT_{A} to IOUT_{D} in section 34 and a second set of matching output streams IOUTB_{A} to IOUTB_{D}, where IOUTB means I̅O̅U̅T̅, and wherein IOUT_{A} is paired with IOUTB_{A}, IOUT_{B} is paired with IOUTB_{B}, and so on and so forth.

Focusing on the first section 34 by way of example (because the second section 36 operates analogously to the first section 34), there are provided four n-channel MOSFETs 38A to 38D (i.e. one per stream or path) with their source terminals connected together at a common tail node 40.

The aforementioned current source I_{IN} is connected between common tail node 40 and an equivalent common tail node 46 of section 36. A further current source I_{DC} 42 is connected between the common tail node 40 and ground supply, and carries a constant DC current I_{DC}. The gate terminals of the four transistors 38A to 38D are driven by the four clock signals θ₀ to θ₃, respectively, provided from the VCO 24.

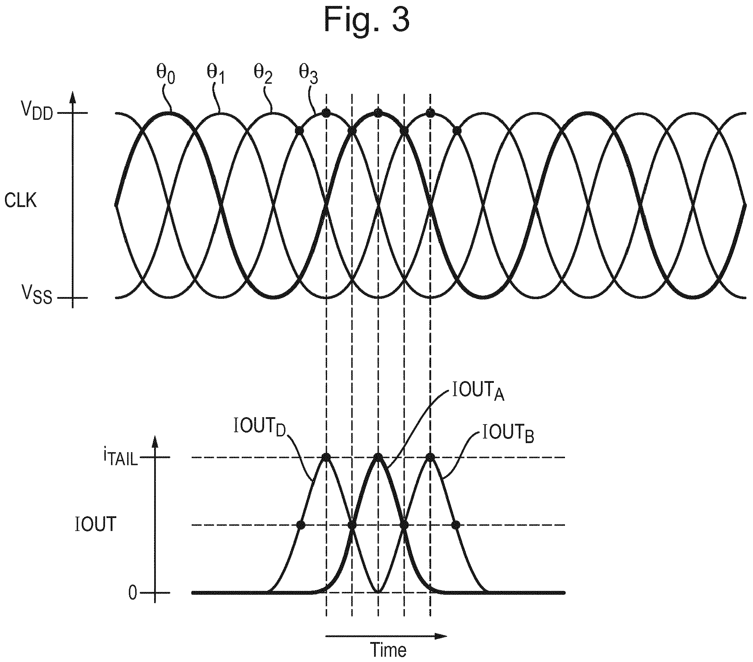

Operation of the sampler 42 will now be explained with reference to Figure 3. As mentioned above, section 36 is structurally similar to section 34 and thus comprises transistors 44A to 44D, common tail node 46 and current source I_{DC} 48 with a similar operation.

**Figure 3** shows waveforms for the clock signals θ₀ to θ₃ in the upper graph, and partial waveforms for the currents IOUT_{A}, IOUT_{B} and IOUT_{D} (current IOUTc is not shown) in the lower graph, for use in better understanding the operation of sampling circuitry 22.

Clock signals θ₀ to θ₃ are time-interleaved raised (substantially) cosine waveforms and are 90° out of phase with one another. The clock signals shown are sinusoidal but need not be strictly-perfect sinusoids. For the benefit of further explanation, clock signal θ₀ is highlighted in bold in Figure 3.

Clock signals θ₀ to θ₃ control the gates of transistors 38A to 38D, respectively, in sampler 22. Accordingly, transistors 38A to 38D are turned on and then off in sequence, such that as one of them is turning off the next in sequence is turning on, and such that when one of them is turned fully on the others are substantially turned off.

Because substantially all current entering node 40 via transistors 38A to 38D must exit that node as current I_{TAIL}, then the sum of currents IOUT_{A} to IOUT_{D} at any time must be substantially equal to I_{TAIL} = I_{DC} - I_{IN}. The effect of the gate control mentioned above is therefore that current I_{TAIL} is steered to pass through transistors 38A to 38D in the sequence in which those transistors are turned on and off, i.e. such that as one of them is turning off and thus starts to carry less of I_{TAIL}, the next in sequence is turning on and thus starts to carry more of I_{TAIL}, and such that when one of them is turned fully on, it carries substantially all of I_{TAIL} because the other transistors are substantially turned off.

This effect is shown in the lower graph of Figure 3. For comparison with the upper graph of clock signals, the waveform for output current IOUT_{A} (corresponding to clock signal θ₀) is highlighted in bold.

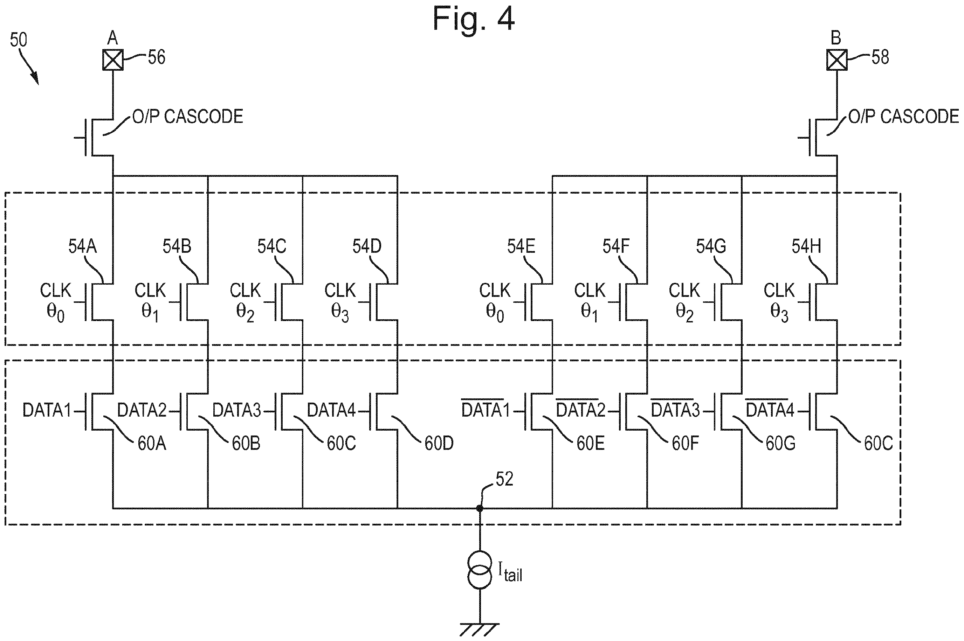

Such clock signals θ₀ to θ₃ may also be used to control differential switching circuitry used in DAC circuitry as disclosed in EP-A1-2849345, which circuitry will now be considered by way of background in relation to time-interleaved DAC circuitry. Indeed, where the ADC circuitry of Figure 1 and DAC circuitry of Figure 4 (described below) are provided together, they may share the same clock signals θ₀ to θ₃.

**Figure 4** shows a differential switching circuit 50, which may be or form part of DAC circuitry as mentioned above. The circuitry comprises a common node 52 (or tail node) to which a current source (or, once and for all, sink) is connected. Four transistors 54A to 54D are shown connected in parallel (along parallel current paths) between the common node 52 and a first output node 56 (node A). Similarly, four transistors 54E to 54H are shown connected in parallel (along parallel current paths) between the common node 52 and a second output node 58 (node B). These transistors will be referred to as output switches hereinafter.

In Figure 4, the gates of the output switches 54A to 54H are driven directly by way of clock signals θ₀ to θ₃. Data-controlled switches 60A to 60H (controlled by data signals DATA1 to DATA4 as in Figure 4) are provided in series connection with the output switches 54A to 54H, respectively, along the corresponding parallel current paths.

Looking at Figure 4, each output switch 54A to 54H effectively becomes one of a pair of series-connected switches (in this case, field-effect transistors). The pairs including 54A to 54D are provided in parallel branches, and similarly the pairs including 54E to 54H are provided in parallel branches.

The clock signals θ₀ to θ₃ supplied to the output switches 54A to 54H are time-interleaved raised (substantially) cosine waveforms and are 90° out of phase with one another, as with the circuitry of Figure 2.

The output switches 54A to 54H and the data-controlled switches 60A to 60H are driven so as, in use, to steer current from the current source through the first output node 56 or the second output node 58 in dependence upon the value (digital 0 or 1) of the data signals DATA1 to DATA4.

In order to achieve this, output switches 54A and 54E are provided with clock signal θ₀, output switches 54B and 54F are provided with clock signal θ₁, output switches 54C and 54G are provided with clock signal θ₂, and output switches 54D and 54H are provided with clock signal θ₃. Moreover, data-controlled switches 60A and 60E are respectively provided with data signals DATA1 and D̅A̅T̅A̅1̅, data-controlled switches 60B and 60F are respectively provided with DATA2 and D̅A̅T̅A̅2̅, data-controlled switches 60C and 60G are respectively provided with DATA3 and D̅A̅T̅A̅3̅, and data-controlled switches 60D and 60H are respectively provided with DATA4 and D̅A̅T̅A̅4̅.

The effect of the 4-phase clock signal is that either output switch 54A or 54E is switched on in a first clock cycle or phase (θ₀), dependent on the value of the data signal DATA1. Similarly, dependent on data, 54B or 54F switches on in a second clock cycle or phase (θ₁), 54C or 54G switches on in a third clock cycle or phase (θ₂) and 54D or 54H switches on in a fourth clock cycle or phase (θ₃). The output switches in Figure 4 are NMOS transistors, and as such turn on in the +ve peak portions of the relevant clock signals.

Accordingly, for each clock cycle, if the value of the data signal concerned is 1 the current I_{TAIL} is steered through node 56 and if it is zero through node 58. Moreover, in each cycle one series-connected transistor pair turns on and one turns off, irrespective of the data.

Output nodes 56 and 58 are connected to the output switches via respective output cascodes as indicated in Figure 4.

Given again an example 14GHz, 4-phase clock signal, this operation leads to an overall sample rate of 56 Gs/s, as with the ADC circuitry of Figure 2.

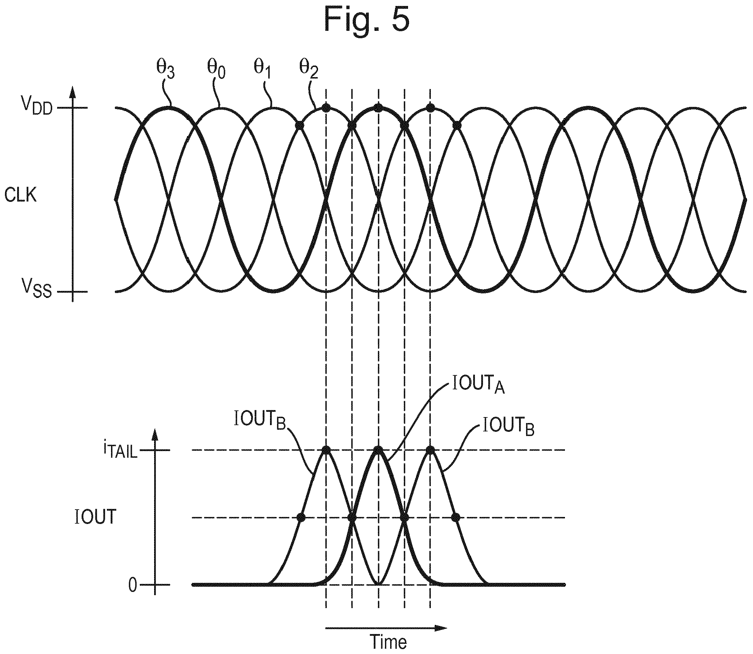

**Figure 5** shows more waveforms for the clock signals θ₀ to θ₃ in the upper graph, and partial waveforms for the currents received at output nodes 56 and 58, labelled as IOUT_{A} and IOUT_{B}, in the lower graph, for use in better understanding the operation of differential switching circuit 50 of Figure 4.

Clock signals θ₀ to θ₃ control the gates of output switches 54A to 54H, as already described in connection with Figure 4. Accordingly, the output-switch pairs (where the pairs are 54A/54E, 54B/54F, 54C/54G, 54D/54H) are turned on and then off in sequence, such that as one of them is turning off the next in sequence is turning on, and such that when one of them is turned fully on the others are substantially turned off. As mentioned before, which switch of such an output-switch pair carries a current pulse when the pair is turned on is dependent on the data signal (of DATA1 to DATA4) concerned.

Because substantially all current passing through the common node via switches 54A to 54H must equal current I_{TAIL}, then the sum of currents flowing through nodes 56 and 58 at any time must be substantially equal to I_{TAIL}. The effect of the data-controlled switches 60A to 60H mentioned above is therefore that current I_{TAIL} is steered to pass through one switch from each output-switch pair in the sequence in which those output-switch pairs are turned on and off, i.e. such that as one of the output-switch pairs is turning off and thus one of its output switches starts to carry less of I_{TAIL}, the next output-switch pair in sequence is turning on and thus one of its output switches starts to carry more of I_{TAIL}, and such that when one of the output-switch pairs is turned fully on, one of its output switches carries substantially all of I_{TAIL} because the other output switch of that pair has its series-connected data-controlled switch substantially turned off and because the output switches of the other output-switch pairs are substantially turned off.

This effect is shown in the lower graph of Figure 5. For comparison with the upper graph of clock signals, the waveform for the output current corresponding to clock signal θ₃ is highlighted in bold.

From Figures 2 to 5, it will be apparent that the accuracy of the operation of such ADC and DAC circuitry is dependent on the accuracy of the clock signals θ₀ to θ₃ as received at the relevant transistors driven by those signals, with for example clock skew (timing/phase errors) between them affecting the relative sizes of the current pulses in the low graph of Figures 3 and 5. Timing errors between each of the multiple clock phases, known as clock skew, as provided to the relevant transistors (see Figures 2 and 4) thus manifests itself as (frequency-domain) spurs in the output signal of the ADC/DAC. Such timing/phase errors may be introduced by the VCO or other clock generation circuitry and/or along clock paths carrying those clock signals. The introduction of spurs from the clock skew may for example cause the signal-to-noise distortion ratio (SNDR) bandwidth or effective number of bits (ENOB) bandwidth of the ADC or DAC to be reduced.

It will be appreciated that other circuitry (signal processing circuitry) operating based on multiphase clock signals (or clock signals which have a desired timing relationship) may suffer similar problems related to clock signal timing/phase errors.

It is desirable to address the above-mentioned problems.

According to an embodiment of a first aspect of the present invention there is provided a method of performing performance tests to determine calibrated configurations for clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result, the method comprising: with a variable X having an initial value of 1, where 1≤X≤N: as a step A, performing an Xth series of performance tests corresponding to the Xth clock line, wherein the set configurations are updated between successive tests of that series of performance tests so that the set configuration of the Xth variable element is different from test to test across those tests and the set configuration of at least one other variable element of the N variable elements is the same from test to test across those tests; and as a step B, identifying an analysis result of the Xth series of performance tests which indicates a target performance relative to the other analysis results of the Xth series of performance tests, and associating the configuration of the Xth variable element set for the test corresponding to that identified analysis result with the Xth variable element as the identified configuration for the Xth variable element; performing other performance tests, wherein the set configurations are updated between successive tests of the other performance tests so that the combination of set configurations for the N variable elements is different from test to test, and the set configuration of each variable element having an identified configuration is its identified configuration from test to test, across those other performance tests, and wherein fewer other performance tests are performed than the number of performance tests required for all possible combinations of configurations from the corresponding sets of configurations for the N variable elements to have been tested in said method; and identifying an analysis result of the performed performance tests which indicates a target performance relative to other analysis results of the performed performance tests, and determining the respective configurations for the N variable elements set for the test corresponding to that identified analysis result to be the respective calibrated configurations for the N variable elements.

The method may advantageously enable the calibrated configurations to be obtained in an efficient manner, saving time and cost associated with calibration. The calibrated configurations may be suitable to reduce or minimise clock skew between the N clock signals as received by the signal processing circuitry. The number of performance tests which need be performed to obtain the calibrated configurations may be lower (e.g. substantially lower) than the number required for a brute force approach testing all possible combinations of configurations.

The clock-controlled circuitry may for example be considered a combination of the signal-processing circuitry and the clock lines arranged with the Nth variable elements, optionally also comprising a clock generator connected to the clock lines for providing the N-phase clock signal. The signal-processing circuitry may be a converter, operable to convert its input signal into its output signal. For example, the signal-processing circuitry may be an ADC or DAC.

The N-phase clock signal may be considered a multiphase clock signal, made up of the N clock signals. The phases of N clock signals may be spread equally in phase. The N clock signals may have the same clock frequency fc.

The method may comprise, in performing the other performance tests,: repeating steps A and B at least once, with the variable X having, for each successive repetition of steps A and B, a value in the range 1≤X≤N for which steps A and B have not yet been performed.

The repeating steps A and B at least once may comprise repeating steps A and B until steps A and B have been performed for all values of X in the range 1≤X<N. The repeating steps A and B at least once may comprise, after repeating steps A and B until steps A and B have been performed for all values of X in the range 1≤X<N, repeating step A and optionally step B for X=N. The number of clock lines (and clock signals) N may be such that N>2 or N≥4.

For each performance of step A, the series of performance tests concerned may be performed consecutively, for example without other performance tests being performed between them. Where step A is performed for different values of X, the plurality of performances of step A may be performed consecutively so that the performance tests of those performances of step A are consecutively-performed performance tests (for example without other performance tests being performed between them). Where step A is performed for different values of X, the performance tests of those performances of step A may be the only performed performance tests. Where step A is performed for different values of X, the identifying an analysis result of the performed performance tests which indicates the target performance relative to the other analysis results of the performed performance tests may comprise identifying an analysis result of the performance tests performed in the plurality of performances of step A.

For each performance of step A, the Xth series of performance tests concerned may comprise a performance test per configuration of the set of configurations corresponding to the Xth variable element concerned. This enables all of the configurations of the set of configurations corresponding to the Xth variable element concerned to be tested, although fewer could be tested in some arrangements.

For each performance of step A, the set configurations may be updated between successive tests of the series of performance tests concerned so that the set configuration of each variable element of the N variable elements other than the Xth variable element concerned is the same from test to test across those tests.

The test input signal may be substantially the same for some or all of the performance tests. The clock-controlled circuitry may be operated in substantially the same way for some or all of the performance tests. The analysis of the generated output signal may be carried out in substantially the same way for some or all of the performance tests.

For each performance test, the analysis result may be a value obtained by summing one or more given frequency-domain signal components in the output signal.

For each performance test: the test input signal may have a dominant frequency ft, the test input signal optionally being a sinusoidal test input signal; the signal processing circuitry may have a sampling frequency fs, optionally defined by fs = N*fc, where fc is the clock frequency of the N clock signals of the N-phase clock signal; and the given frequency-domain signal components may comprise the frequency-domain signal components at the frequencies k*fs/N ± ft, for 1≤k≤N where k is an integer, up to the Nyquist frequency fs/2 (and including aliases).

The frequency-domain signal components may be frequency-domain signal powers. The frequency-domain signal components may be image spurs. The frequency-domain signal components may comprise pairs of image spurs centred in frequency around the frequencies k*fs/N, for 1≤k≤N where k is an integer, up to the Nyquist frequency fs/2 and including aliases.

For each performance of step A, the analysis result of the Xth series of performance tests concerned which indicates the target performance relative to the other analysis results of the Xth series of performance tests may be the one of those analysis results which has the smallest sum of signal components or result of integrating signal components.

The analysis result of the performed performance tests which indicates the target performance relative to the other analysis results of the performed performance tests may be the one of those analysis results which has the smallest sum of signal components or result of integrating signal components.

For each performance test, the analysis result may be an ENOB or SNDR bandwidth of the signal processing circuitry. For each performance of step A, the analysis result of the Xth series of performance tests concerned which indicates the target performance relative to the other analysis results of the Xth series of performance tests may be the one of those analysis results which has the largest ENOB or SNDR bandwidth.

The analysis result of the performed performance tests which indicates the target performance relative to the other analysis results of the performed performance tests may be the one of those analysis results which has the largest ENOB or SNDR bandwidth.

The method may comprise: storing the analysis results as they are produced; or as the analysis results are produced, storing a running analysis result (e.g. overall or per step A) being the analysis result of the produced analysis results which indicates the target performance relative to the other analysis results of the produced analysis results.

The method may comprise recording configurations corresponding to the calibrated configurations for the clock-controlled circuitry on or in association with that clock-controlled circuitry.

The N variable elements may be variable impedances and, for each variable impedance, the configurations of the set of configurations may cause that variable impedance to have respective impedance values. The N variable elements may be configured to vary the lengths of their respective clock lines, wherein, for each variable element, the configurations of the set of configurations cause the clock line concerned to have respective clock line lengths.

Such variable impedances may be variable capacitors or variable inductors or variable resistors or combinations thereof.

Where the N variable impedances are variable capacitors, the method may comprise, between successive performance tests,: conductively disconnecting the N variable elements from their respective clock lines; and/or conductively connecting the N variable elements so as to discharge any charge stored on those variable elements or to bring an amount of charge stored on each of those variable elements to a corresponding reset amount.

The N variable impedances may be variable capacitors each comprising a plurality of component capacitors, the method comprising, for at least one performance test, connecting component capacitors of a pair of said clock lines together in series between those clock lines.

The signal processing circuitry may be mixed-signal circuitry, for example at least part of an analogue-to-digital converter or a digital-to-analogue converter.

For each performance of step B, the analysis result of the Xth series of performance tests concerned which indicates a target performance relative to the other analysis results of that Xth series of performance tests may be the analysis result of the Xth series of performance tests concerned which indicates a better performance than the other analysis results of that Xth series of performance tests. The analysis result of the performed performance tests which indicates a target performance relative to other analysis results of the performed performance tests may be the analysis result of the performed performance tests which indicates a better performance than the other analysis results of the performed performance tests.

According to an embodiment of a second aspect of the present invention there is provided a method of calibrating clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, the method comprising: carrying out a method according to the aforementioned first aspect of the present invention on said clock-controlled circuitry; and setting the configurations of the N variable elements to their respective calibrated configurations.

According to an embodiment of a third aspect of the present invention there is provided apparatus for performing performance tests to determine calibrated configurations for clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result, the apparatus configured to control the clock-controlled circuitry to carry out a method according to the aforementioned first aspect of the present invention.

The apparatus may comprise a memory configured to record configurations corresponding to the calibrated configurations for the clock-controlled circuitry on or in association with that clock-controlled circuitry. The apparatus may comprise the clock-controlled circuitry.

According to an embodiment of a fourth aspect of the present invention there is provided integrated circuitry comprising apparatus according to the aforementioned third aspect of the present invention.

According to an embodiment of a fifth aspect of the present invention there is provided a computer program which, when executed on apparatus for performing performance tests to determine calibrated configurations for clock-controlled circuitry, causes the apparatus to carry out a method, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result, the method being a method according to the aforementioned first aspect of the present invention.

According to an embodiment of a sixth aspect of the present invention there is provided a computer-readable medium having a computer program according to the aforementioned fifth aspect of the present invention stored thereon.

According to an embodiment of a seventh aspect of the present invention there is provided a method of performing performance tests to determine calibrated configurations for first and second clock-controlled circuitry, the method comprising: carrying out a method according to the aforementioned first aspect of the present invention for the first clock-controlled circuitry; and carrying out a method according to the aforementioned first aspect of the present invention for the second clock-controlled circuitry, wherein: for the first clock-controlled circuitry, the input signal is a digital input signal, the signal processing circuitry is configured to perform digital-to-analogue conversion, and the output signal is an analogue output signal; and for the second clock-controlled circuitry, the input signal is an analogue input signal, the signal processing circuitry is configured to perform analogue-to-digital conversion, and the output signal is a digital output signal; the N clock signals of the N-phase clock signal for the first clock-controlled circuitry are controlled to have a clock frequency fc1 and the N clock signals of the N-phase clock signal for the second clock-controlled circuitry are controlled to have a clock frequency fc2, where fc1≠fc2, so that sampling rates of the first and second clock-controlled circuitry are different; at least one of the performance tests for the first clock-controlled circuitry is performed with at least one of the performance tests for the second clock-controlled circuitry as a combined performance test with the first and second clock-controlled circuitry connected together so that: the analogue input signal of the second clock-controlled circuitry is or is derived from the analogue output signal of the first clock-controlled circuitry; and the analysing in respect of the first and second clock-controlled circuitry is carried out on the digital output signal of the second clock-controlled circuitry. All of the performance tests for the first clock-controlled circuitry may be performed with the corresponding performance tests for the second clock-controlled circuitry as respective combined performance tests.

According to an embodiment of an eighth aspect of the present invention there is provided a method of performing performance tests to determine calibrated configurations for first and second clock-controlled circuitry, wherein: each of the first and second clock-controlled circuitry comprises: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1; each performance test comprises setting the configurations of the N variable elements of the clock-controlled circuitry concerned to respective configurations selected from their respective sets of configurations, operating the clock-controlled circuitry concerned based on the N-phase clock signal with the N variable elements having their respective set configurations for that performance test and with a test input signal supplied to the signal processing circuitry, and analysing the generated output signal to produce a corresponding analysis result; for the first clock-controlled circuitry, the input signal is a digital input signal, the signal processing circuitry is configured to perform digital-to-analogue conversion, and the output signal is an analogue output signal; and for the second clock-controlled circuitry, the input signal is an analogue input signal, the signal processing circuitry is configured to perform analogue-to-digital conversion, and the output signal is a digital output signal, the method comprising: controlling the N clock signals of the N-phase clock signal for the first clock-controlled circuitry to have a clock frequency fc1 and the N clock signals of the N-phase clock signal for the second clock-controlled circuitry to have a clock frequency fc2, where fc1≠c2, so that sampling rates of the first and second clock-controlled circuitry are different; performing the performance tests for the first and second clock-controlled circuitry with at least one pair of performance tests, which performance tests correspond respectively to the first and second clock-controlled circuitry, performed as a combined performance test with the first and second clock-controlled circuitry connected together so that: the analogue input signal of the second clock-controlled circuitry is or is derived from the analogue output signal of the first clock-controlled circuitry; and the analysing in respect of the first and second clock-controlled circuitry is carried out on the digital output signal of the second clock-controlled circuitry; performing the performance tests for the first and second clock-controlled circuitry with, for each of the first and second clock-controlled circuitry, the set configurations updated between successive combined performance tests so that the combination of set configurations for its N variable elements is different from test to test; and for each of the first and second clock-controlled circuitry, identifying an analysis result of the performed performance tests which indicates a better performance than the other analysis results of the performed performance tests, and determining the respective configurations for the N variable elements set for the test corresponding to that identified analysis result to be the respective calibrated configurations for the N variable elements. All of the performance tests for the first clock-controlled circuitry may be performed with the corresponding performance tests for the second clock-controlled circuitry as respective combined performance tests.

According to an embodiment of a ninth aspect of the present invention there is provided a method of performing performance tests to determine calibrated configurations for clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result. For each performance test, the analysis result may be a value obtained by summing or integrating one or more given frequency-domain signal components in the output signal. For each performance test: the test input signal may have a dominant frequency ft, the test input signal optionally being a sinusoidal test input signal; the signal processing circuitry may have a sampling frequency fs, optionally defined by fs = N*fc, where fc is the clock frequency of the N clock signals of the N-phase clock signal; and the given frequency-domain signal components may comprise the frequency-domain signal components at the frequencies k*fs/N ± ft, for 1≤k≤N where k is an integer, up to the Nyquist frequency fs/2 (and including aliases).

Method aspects may apply *mutatis mutandis* to apparatus, program and storage medium aspects. For example, the present disclosure extends to apparatus, program and storage medium aspects which correspond to the above seventh to ninth aspects of the present invention.
Figure 1, considered above, is a schematic diagram of previously-considered ADC circuitry;
Figure 2, considered above, is a schematic circuit diagram of a four-phase current-mode sampler of the ADC circuitry in Figure 1;
Figure 3, considered above, shows waveforms of clock signals θ0 to θ3 in its upper graph, and partial waveforms of currents IOUTA, IOUTB and IOUTD in its lower graph;
Figure 4, considered above, is a schematic diagram presenting a differential switching circuit for use in a previously-considered DAC;
Figure 5, considered above, shows waveforms for clock signals θ0 to θ3 in its upper graph, and partial waveforms for currents received at output nodes 56 and 58 of the Figure 4 differential switching circuit in its lower graph;
Figure 6 is a schematic diagram of apparatus embodying the present invention;
Figure 7 is a graph which shows how integrated image spurs levels vary across 4096 configuration combinations, in relation to a first technique;
Figure 8 is a graph showing an improvement in SNDR bandwidth achieved by the first technique;
Figure 9A is a flow diagram of a method of performing performance tests to determine calibrated impedance values for clock-controlled circuitry, in accordance with a second technique;
Figure 9B is a flow diagram which details one possible implementation of one of the steps of the Figure 9A method;
Figure 10 is a graph showing analysis results relating to the combinations used in the

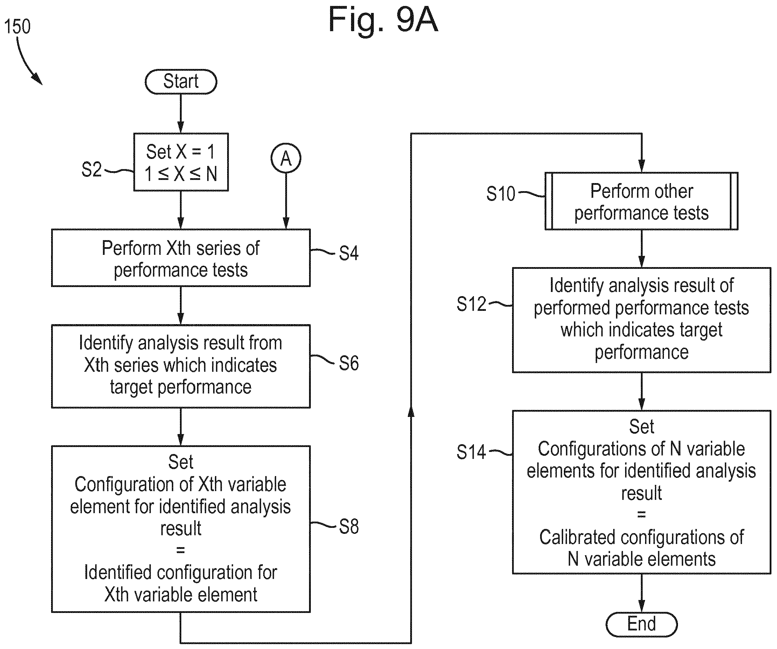

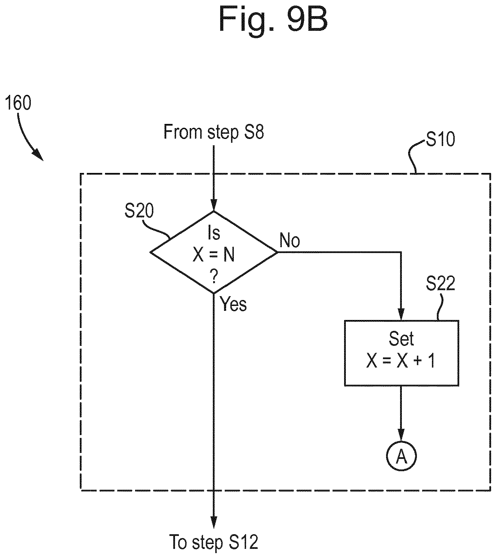

Figure 9A method with specific implementation of Figure 9B;

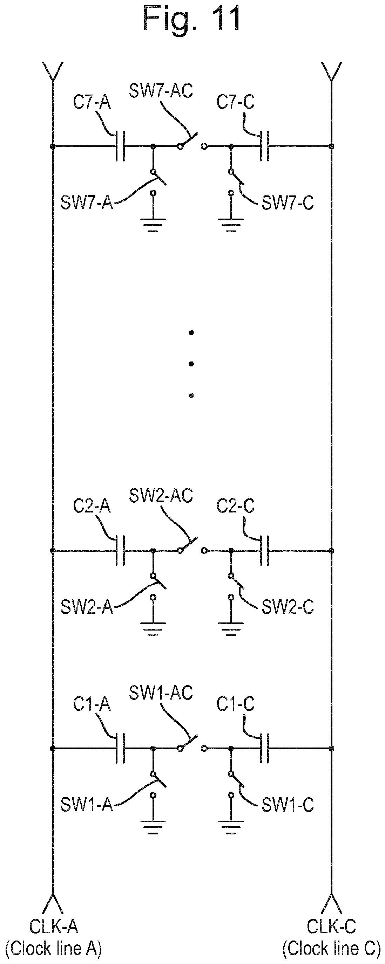

Figure 11 is a schematic diagram useful for understanding how, in an example where the variable elements are variable capacitors each comprising switchable capacitors, the switching of the capacitors may be implemented;

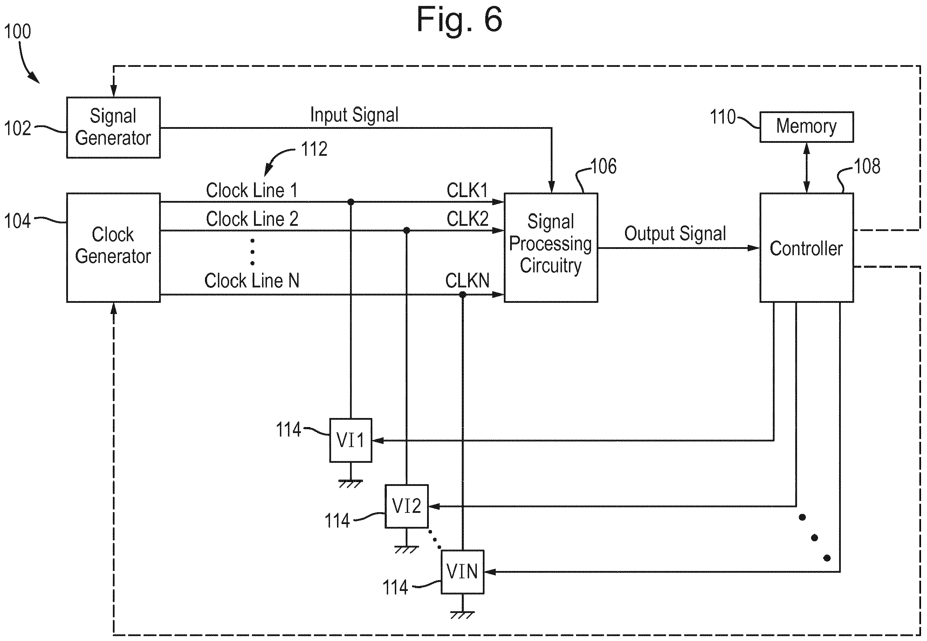

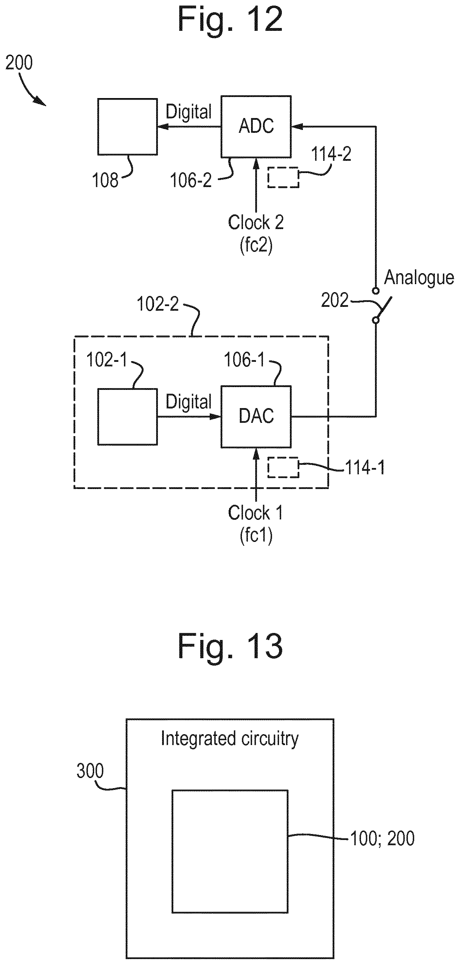

Figure 12 is a schematic diagram of a system useful for understanding that the Figure 6 apparatus may be expanded to determine calibration configurations for two sets of clock-controlled circuitry together; and
Figure 13 is a schematic diagram of integrated circuitry embodying the present invention.

**Figure 6** is a schematic diagram of apparatus 100 embodying the present invention.

It will become apparent that apparatus 100 may be employed to carry out first and second techniques of performing performance tests to determine calibrated configurations for clock-controlled circuitry. The first technique is described at least in part to enable advantages associated with the second technique to be better understood. Particular embodiments of the present invention relate to the apparatus 100 when configured in accordance with the second technique.

The apparatus 100 comprises a signal generator 102, a clock generator 104, signal processing circuitry 106, a controller 108, a memory 110, first to Nth clock lines 112 and first to Nth variable impedances (variable elements) 114, where N is an integer and N>1.

As apparent from Figure 6, the signal generator 102 is operable to generate an input signal and is connected to supply the input signal to the signal processing circuitry 106. Similarly, the clock generator 104 is operable to generate a multiphase (N-phase) clock signal comprising first to Nth clock signals CLK1 to CLKN and is connected via respective clock lines 112 (CLOCK LINE 1 to CLOCK LINE N) to supply those clock signals to the signal processing circuitry 106.

The first to Nth variable impedances 114 are connected to the respective clock lines 112, in the present example between the clock lines 112 and ground (GND). Thus, the impedance of the clock lines carrying the N-phase clock signal may be individually adjusted by individually adjusting the first to Nth variable impedances 114.

It is noted here that the variable impedances 114 are examples of variable elements which can be configured into a selected one of a corresponding set of configurations which affect a property of the clock line concerned. In this example, the configurations correspond to impedance values. The variable impedances 114 could be variable capacitors, and indeed this example will be adopted for simplicity later herein as a running example. The connection of the variable impedances 114 in Figure 6 between the clock lines 112 and ground (GND) is an example with variable capacitors in mind. However, the variable elements could be other types of variable impedances (resistors, capacitors, inductors, or combinations thereof). As another example, the variable elements could be circuit arrangements which serve to adjust the length of their corresponding clock lines (by virtue of their different configurations), with appropriate connections to the clock lines, this also affecting a property (i.e. length, clock propagation time) of the clock lines. The example of variable impedances (in particular, variable capacitors) will be carried forwards, however such other possibilities will be kept in mind and the present disclosure will be understood accordingly.

In some arrangements, the variable impedances (especially variable capacitors) may be at least partly connected between adjacent clock lines for carrying clock signals which are 180° out of phase with one another (as explained in more detail later). The example as depicted in Figure 6 will be carried forwards for simplicity, but will be understood to be schematic and to encompass such connections between clock lines in a practical implementation.

As above, the first to Nth variable impedances 114 may be in the form of passive (discrete) electronic components such as resistors, inductors or capacitors or a combination thereof. Furthermore, each of the first to Nth variable impedances 114 may be implemented using single (discrete) electronic components whose impedances can be adjusted to select from a range of different impedance values, or may be implemented as a bank of discrete impedances which can be selectively switched into or out of circuit to vary the impedance value of the variable impedance 114. For ease of understanding, the example in which the first to Nth variable impedances 114 are variable capacitances 114 will be carried forwards (however it will be understood that other types of variable impedance - or indeed variable element - may be employed). Another possibility is to switch in different active circuits which have a different typical value, to track and compensate for external changes such as die temperature or supply voltage.

The signal processing circuitry 106 is configured to generate an output signal based on the input signal and the multiphase clock signal comprising the first to Nth clock signals CLK1 to CLKN. For example, the input signal may be an analogue input signal, the signal processing circuitry 106 may be configured to perform analogue-to-digital conversion and the output signal may be a digital output signal. As another example, the input signal may be a digital input signal, the signal processing circuitry 106 may be configured to perform digital-to-analogue conversion and the output signal may be an analogue output signal. In both cases, the multiphase clock signal may control the sampling and sample rate of the signal processing circuitry 106.

The controller 108 is connected to receive the output signal from the signal-processing circuitry 106, and to control the variable capacitances 114 so as to control their capacitances (i.e. impedances). The controller 108 is also connected to the memory 110, to store information in the memory 110 and retrieve such stored information, as will become apparent.

The controller 108 may be operable to control the signal generator 102, for example to control the input signal (e.g. a frequency of the input signal where it is a sinusoidal input signal, and/or when the input signal is generated), however this may be controlled separately. The controller 108 similarly may be operable to control the clock generator 104, for example to control the multiphase clock signal (e.g. the clock frequency and/or when the multiphase clock signal is generated), however this again may be controlled separately.

Indeed, the signal generator 102 and clock generator 104 may be provided separately such that the input and clock signals are simply received by the signal processing circuitry 106 over corresponding signal lines from an external source. In this regard, the signal processing circuitry 106, along with the clock lines 112 and signal lines for carrying the input and output signals may be provided as or as part of an integrated circuit such as an application-specific integrated circuit (ASIC), e.g. on an IC chip, with the other elements of the apparatus 100 provided separately (e.g. off chip, or even off IC chip package such as in external equipment).

The variable impedances 114 along with their connections to the clock lines 112 and signal lines to receive control signals from the controller 108 may be provided as part of the integrated circuit (rather than for connection thereto). The signal generator 102 and/or the clock generator 104 may be provided as part of the integrated circuit (rather than for connection thereto). The controller 108 and/or the memory 110 may be provided as part of the integrated circuit (rather than for connection thereto). It will therefore be appreciated that different embodiments may provide different divisions between on-chip and off-chip components from one another.

Going forwards, it will be assumed that N is 4 (i.e. N=4) as an example, however as above N may be any integer where N>1. Thus, it will be assumed that the apparatus 100 has four different clock lines 112 (first, second, third and fourth clock lines), and that the multiphase clock signal is a quadrature clock signal having four phases CLK1 to CLK4. It will also be assumed that each of the variable impedances 114 is a variable capacitor (as mentioned above) whose capacitance can be controlled to adopt one of a set of 8 different capacitance values (corresponding to a set of 8 different configurations). In particular, in the present running example each variable capacitor 114 will be assumed to be implemented as 7 switchable capacitors (which may have the same capacitance value as one another), where any number of them in a given order or none of them (i.e. 0 to 7) can be switched into circuit thus providing 8 different capacitance values (configurations) for the clock line 112 concerned. Another possibility would be to provide 3 switchable capacitors having binary-weighted relative capacitances a, 2a, 4a, where any combination of them or none would provide 8 different capacitances (i.e. configurations), however the example using 7 switchable capacitors will be carried forwards. Thus, across the clock lines 112 in the present example the total number of possible capacitance value (configuration) combinations is 4096 (i.e. 8x8x8x8=4096). These configuration combinations could be expressed as [0,0,0,0] up to [7,7,7,7], where combination [0, 5, 6, 7] means that clock line 1 has 0, clock line 2 has 5, clock line 3 has 6, and clock line 4 has 7 of its switchable capacitors connected thereto in this example.

In alternative embodiments, N may be greater or less than 4 and the number of different capacitance values for each clock line may be greater than or less than 8 (e.g. 2 or more). For example, in another example each variable capacitor 114 could be implemented as 8 switchable capacitors, where any number of them in a given order or none of them (i.e. 0 to 8) can be switched into circuit thus providing 9 different capacitance values for the clock line 112 concerned and 6561 (i.e. 9x9x9x9=6561) possible capacitance value combinations across the clock lines 112, keeping N=4 for simplicity.

The first technique will be described before the second technique by way of introduction and also as mentioned above to help an appreciation of the benefits of the second technique over the first technique.

An aim of both the first and second techniques is to determine a combination of the capacitance (impedance) values of the variable capacitances (impedances) 114 (configurations of the variable elements) which gives a desired or target performance of the signal processing circuitry 106. For example, the capacitance values selected for the variable capacitance 114 may affect the clock skew (between the clock signals CLK1 to CLK4) or other timing/phase errors between the clock signals CLK1 to CLK4 experienced by the signal processing circuitry 106, and this may manifest itself in the sizes (magnitudes or powers) of frequency-domain image spurs in the output signal. Thus, as an example, the first and second techniques may aim to reduce to below a threshold level or reduce as far as possible or minimise one or a combination (e.g. integration, or sum in the linear power sense) of image spurs (frequency components) in the output signal.

For convenience, it will be assumed here that the input signal is sinusoidal with a frequency ft (tone frequency) and that the example clock signals CLK1 to CLK4 have a clock frequency fc=fs/4 (where N=4) which defines the sample rate fs (sampling frequency) of the signal processing circuitry 106, assuming again for convenience that the signal processing circuitry 106 operates as an analogue-to-digital or digital-to-analogue converter. It will also be assumed in this example that the first and second techniques aim to minimise the integrated (summed, in terms of linear powers) frequency-domain image spurs level (e.g. expressed in dBFS) of the image spurs located at the group of frequencies fs/4 + ft, fs/4 - ft, and fs/2 - ft (again assuming N=4 as above), and aliasing below the Nyquist frequency fs/2. More generically, image spurs of interest may occur as pairs of image spurs centred in frequency (i.e. ± ft) around fs/2, fs/4 and/or fs/N, or around centre frequencies k*fs/N, where k is an integer and 1≤k≤N, and the present technique may take into account those of them (including aliasing) up to the Nyquist frequency fs/2. The integrated image spurs level may be arrived at by summing absolute (linear) power values of some or a plurality of them (and converting back into logarithmic scale if expressed in dBFS).

It has been found that the integrated image spurs level is representative of the clock skew experienced by the signal processing circuitry 106, and thus that by finding the combination of capacitance values (of the variable capacitors 114) which minimises the integrated image spurs level it is possible to minimise the clock skew experienced by the signal processing circuitry 106. It is emphasised that the aim to minimise rather than reduce to below a threshold amount is an example, as is the specific group of frequencies mentioned above.

In the first technique, then, the controller 108 is configured to perform a performance test for each of the 4096 combinations of configurations or capacitance values [0,0,0,0] to [7,7,7,7], one-by-one in turn, to determine which combination minimises the integrated image spurs level. The first technique may thus be considered a "brute force" approach.

Each test comprises setting the capacitance values of the four variable capacitors to respective capacitance values selected for that test, e.g. [0,3,5,7], from their respective sets of eight capacitor values, operating the signal-processing circuitry 106 based on the four phase clock signal (with each of the component clock signals having clock frequency fs/4, mentioned above) with a test input signal (the sinusoidal input signal having frequency ft, mentioned above), and analysing the generated output signal to produce a corresponding analysis result.

The analysis for each performance test, in the present example, comprises performing a Fast Fourier Transform (FFT) on the output signal in order to assess the above group of image spurs (in the present example, at fs/4 + ft, fs/4 - ft, and fs/2 - ft). However, methods other than FFT for performing frequency analysis may of course be employed. Other examples include calculating an SNDR or ENOB bandwidth of the signal processing circuitry 106 (e.g. ADC or DAC or signal converter) for each performance test, with the aim to maximise the SNDR or ENOB bandwidth.

Continuing the present example, the output signal here is a combined output signal and thus is affected by all four (where N=4) clock phases. The image spur levels, here in dBFS (decibels relative to full scale) assuming digital results of the FFT process, for the above group of image spurs are then summed to provide an integrated image spurs level (an absolute power value), here also in dBFS.

After all combinations have been tested in the first (brute force) technique, the combination of capacitance values (configurations) which provides the minimum integrated image spurs level in the output signal is considered the "best" combination, i.e. the combination which is assumed to minimise the clock skew or clock timing/phase errors experienced by the signal-processing circuity 106. The capacitance values of this best combination (e.g. [0,1,4,7]) are referred to as the calibrated capacitance values (or more generally, calibrated configurations) for the signal-processing circuitry 106 (clock-controlled circuitry).

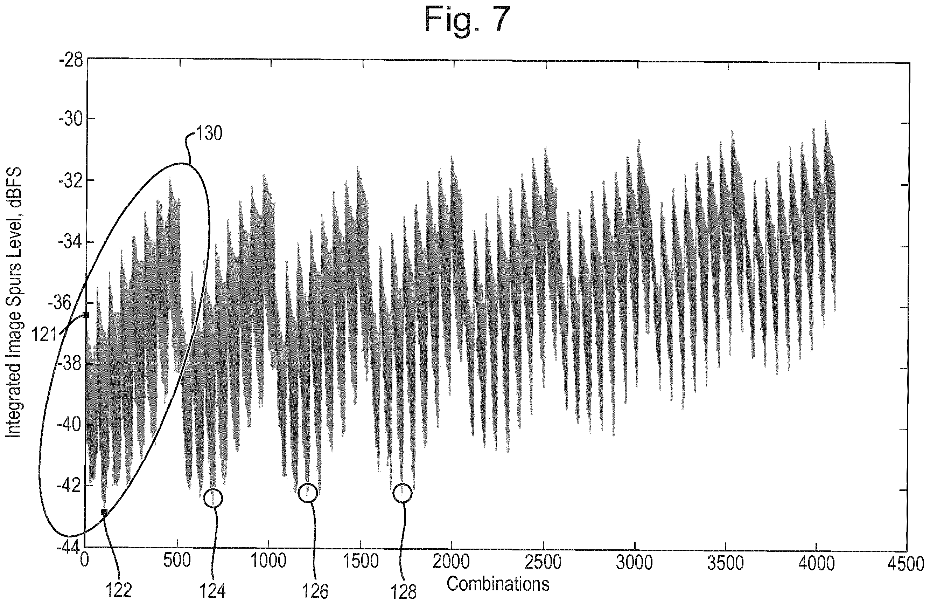

**Figure** 7 is a graph which shows how the integrated image spurs level (the magnitude of integrated image spurs) varies across all 4096 combinations (for example, the analysis results gained from operating according to the first technique). The y-axis of Figure 7 shows integrated image spurs level in dBFS. The x-axis of Figure 7 represents the different combinations of capacitance values (configurations) simply numbered from 0 to 4095 in the order that the combinations were tested (i.e. 4096 combinations in total). In the example illustrated in Figure 7, the "uncalibrated" non-trimmed configuration [0,0,0,0] was the 1^{st} tested combination giving the result 121 and the minimum integrated image spurs level 122 occurred for the 104^{th} tested combination as indicated, which was for combination [0,1,4,7]. The difference between the integrated image spurs levels for points 121 and 122 is around 6.5dB, as can be seen in Figure 7.

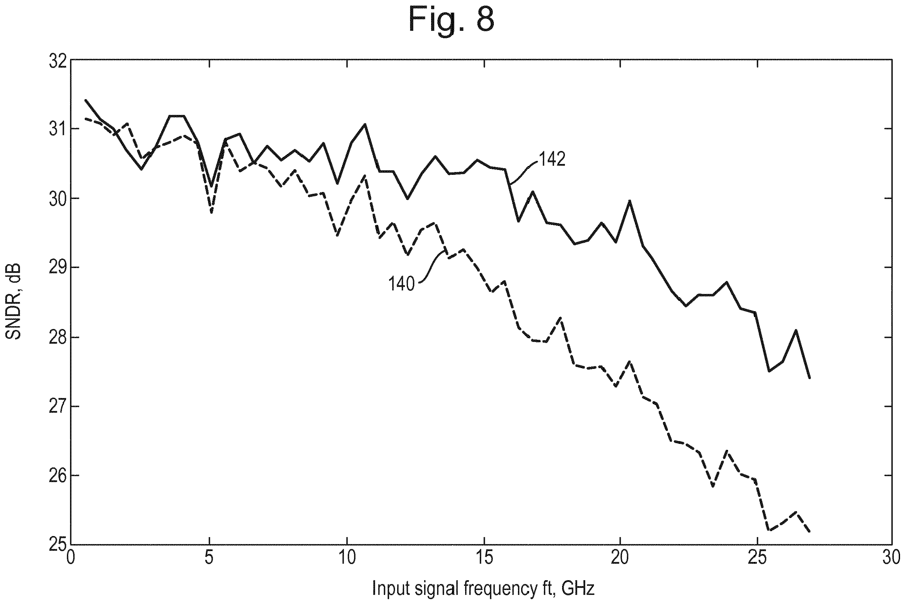

**Figure** 8 is a graph showing the improvement in SNDR bandwidth achieved by this first technique compared to performing no calibration process such as clock skew compensation (for example, setting all of the variable capacitors to have the same "default" capacitance value by not connecting any of the 7 capacitors in each case to the clock line concerned, i.e. combination [0,0,0,0]). The y-axis shows the SNDR of the signal processing circuitry 106, in dB. The x-axis shows the frequency range of the input signal ft. Characteristic 140 illustrates the bandwidth before clock skew compensation is performed (i.e. in the default case mentioned above, for example combination [0,0,0,0]) and characteristic 142 illustrates the bandwidth after clock skew compensation (the first technique) has been performed and the capacitance values have been set to their respective calibrated capacitance values (the combination which provides the minimum integrated image spurs level in the output signal). As can be seen by comparing these two characteristics, the bandwidth in terms of SNDR is improved by 50% when the first technique is employed. It will be appreciated from Figure 8 that the analysis in each performance test could involve measuring the frequency bandwidth (e.g. SNDR bandwidth or ENOB bandwidth) to see which performance test gives the largest bandwidth, rather than considering integrated image spurs.

A downside of the "brute force" first technique is however that every combination of capacitance values (variable element configurations) is tested, in the present example [0,0,0,0] to [7,7,7,7], in order to determine the best combination. Due to the large number of combinations available (i.e. 4096 in this example) the first technique can involve a huge amount of time and resources (e.g. performing 4096 performance tests could take several hours).

The second technique addresses this shortcoming of the first technique, and enables a reduced number of capacitor combinations (variable element configurations) to be tested in order to identify a combination of capacitance values which provides the (or, taking noise into account, very close to the) minimum integrated image spurs level in the output signal. As such, the second technique requires a shorter amount of time and thus fewer resources as compared to the first technique, but still achieves the same or substantially the same performance results (in terms of the reduction or elimination of clock timing/phase errors).

Looking back to the first (brute force) technique and for example Figures 6 and 7, it will be appreciated that certain tested combinations may be expected to give similar analysis results (i.e. integrated image spurs levels). It will also be appreciated from Figure 7 in particular that there is a pattern in the analysis results in the brute force approach (first technique) which can be taken advantage of by the second technique.

For example, the pattern 130 can be seen to repeat at least approximately in the direction of the x-axis, each approximate instance of the pattern 130 relating to a different configuration (i.e. 0 to 7) on a first one of the clock lines (with the brute force approach across the other clock lines occurring within each of those instances of the pattern). It can be seen that there is an upwards trend from left-to-right in Figure 7, indicating that there is strong trend for increase in the integrated image spurs level as the configuration steps from 0 to 7 for the first one of the clock lines. Thus, although there is some similarity in the integrated image spurs level between point 122 and points 124, 126 and 128, the impact of noise must be taken into account and points 124, 126 and 128 are not alternative minimum points. Noise may affect the measured integrated image spurs levels to a (small) degree, although this can be at least partly reduced or smoothed out by testing each combination multiple times and averaging the analysis results.

The second technique takes advantage of this pattern to operate a search tree approach to identify a combination of capacitance values which provides the (or, taking noise into account, very close to the) minimum integrated image spurs level in the output signal.

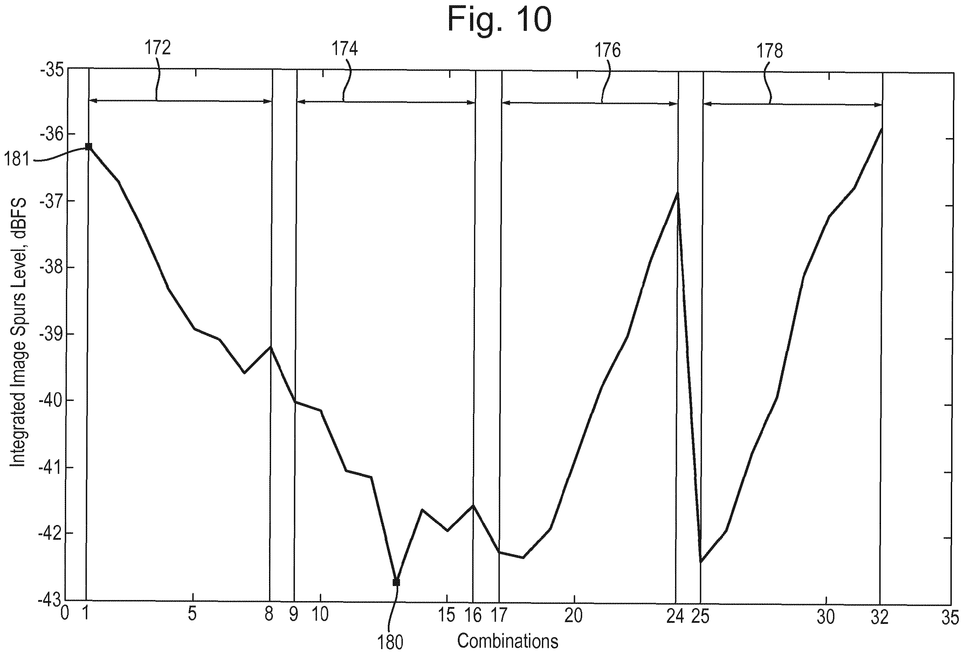

An example of the second technique will now be described with reference to Figures 9A, 9B and 10, in relation to the apparatus 100 of Figure 6 for ease of understanding. The example configuration where N=4 and each line has 7 switchable capacitors 114 (giving available combinations [0,0,0,0] to [7,7,7,7]) will be continued.

**Figure 9A** is a flow diagram of a method 150 of performing performance tests to determine calibrated impedance values for clock-controlled circuitry, in accordance with the second technique. The method 150 of Figure 9A is executed on the apparatus 100 of Figure 6, under control by the controller 108 (which may be implemented in hardware or as a processor executing a computer program). **Figure 9B** is a flow diagram which details one possible implementation 160 of one of the steps of the method 150. **Figure 10** is a graph showing analysis results (in dBFS, as before) relating to the combinations used in method 150 with specific implementation 160.

The method 150 comprises steps S2 to S14.

Prior to the method 150, or as an initial step (not shown), an input signal may be input to the signal processing circuitry 106 in order to determine a tone level and/or frequency which produces relatively large image spurs in the output signal (to enable those spurs to be readily measured), based on the silicon characterisation (assuming an integrated circuitry implementation). Different input tone frequencies may be chosen to optimise performance at higher or lower parts of the SNDR or ENOB bandwidth of the signal processing circuitry 106 (e.g. DAC or ADC). It is incidentally noted that the method 150 (second technique) may be repeated for different supply voltages and different ambient temperature conditions, to obtain calibrated configurations over a range of different operating scenarios. The tone frequency ft selected in the present example was fs/2.5 with precise adjustment for coherent sampling.

In step S2, a variable X, where 1≤X≤N, is set to an initial value of 1. N here is the number of clock lines and phases, as before.

In step S4, an Xth series of performance tests is then carried out, where each performance test comprises setting the configurations of the N variable elements (in this case, variable capacitors) to respective configurations (capacitance values) selected from their respective sets of configurations (capacitance values), operating the clock-controlled circuitry 100 based on the N-phase clock signal with the N variable elements having their respective set configurations for that performance test and with a test input signal (e.g. as configured in the initial step mentioned above) supplied to the signal processing circuitry 106, and analysing the generated output signal (e.g. in the controller 108) to produce a corresponding analysis result. Where X=1, the Xth series of performance tests is a first series of performance tests.

Each analysis result may be stored by the controller 108 in the memory 110, or a running "best" analysis result may be stored by the controller 108 in the memory 110, so that only one analysis result need be stored (that result being updated when a new "best" result is obtained).

In the present example where the variable elements are variable capacitors each comprising 7 switchable capacitors, each performance test may comprise initially disconnecting or discharging the switchable capacitors.

The Xth series of performance tests corresponds to the Xth clock line, so to the first clock line (clock line 1) when X=1. Of course, any of the clock lines may be labelled clock line 1 in an implementation. The set configurations are updated between successive tests of that series of performance tests so that the set configuration of the Xth variable element is different from test to test across those tests and the set configuration of at least one other variable element of the N variable elements is the same from test to test across those tests.

For example, in the present example where the available combinations are [0,0,0,0] to [7,7,7,7], when X=1 the Xth series of performance tests may comprise 8 performance tests in which the respective tested combinations are [0,0,0,0], [1,0,0,0], [2,0,0,0], [3,0,0,0], [4,0,0,0], [5,0,0,0], [6,0,0,0] and [7,0,0,0]. These may be considered to be performance tests 1 to 8 (in any order), with the corresponding combinations also being considered combinations 1 to 8. Of course, it would be possible to test a subset of these 8 combinations to further reduce test time at the expense of finding the best combination, and this also applies to the later series of performance tests describe below. However, in the present example it will be assumed that the present combinations 1 to 8 are tested in the above order.

This would then lead to 8 analysis results, which may be assumed for example to be integrated image spurs levels obtained as described in connection with the first technique above, i.e. performing a Fast Fourier Transform (FFT) on the output signal in order to assess the group of image spurs at the example frequencies (up to the Nyquist frequency) fs/4 + ft, fs/4 - ft, and fs/2 - ft taking account of aliasing. An example set of analysis results for combinations 1 to 8 are plotted in section 172 of Figure 10.

Note that in this example (where X=1) the set configuration of the first variable element is different from test to test across the first series of performance tests and the set configuration of each (rather than at least one) of the other variable elements of the N variable elements is the same from test to test across those tests. In other arrangements, the configuration of any number of the other variable elements of the N variable elements may be the same from test to test across those tests.

In step S6, an analysis result of the Xth series of performance tests which indicates a target performance relative to the other analysis results of the Xth series of performance tests is identified. This may be, where X=1, the performance test with the smallest integrated image spurs level in section 172 of Figure 10.

In step S8, the configuration of the Xth variable element set for the test corresponding to that identified analysis result is then set as the identified configuration for the Xth variable element. Continuing the above example, with X=1, it may be that the performance test of the combination [6,0,0,0] gave the smallest integrated image spurs level of the Xth series of performance tests. Thus, configuration 6 would be set as the identified configuration for the first variable element (variable capacitor).

Thus, in the present example, the first series of performance tests is performed by setting the first variable capacitance to one of the eight available capacitance values available for that first variable capacitance (i.e. seven capacitance values plus zero capacitance), and then updating the first variable capacitance between each successive test of the first series of performance tests so that the set capacitance value of the first variable capacitance is different from test to test across the series of tests and the set capacitance value of the other three variable capacitance of the four variable capacitances is the same from test to test across those tests. That is, the first series of performance tests performs a separate performance test for each of the available capacitance values available to the first variable capacitance (i.e. eight tests for eight available capacitance values) while the other variable capacitances of the second, third and fourth clock lines keep their capacitance values. An analysis result from the first series of performance tests that indicates a better performance compared to the other performance tests is then identified. This involves identifying the analysis result which indicates the smallest integrated image spurs level as having the better performance. The performance test associated with this identified analysis result has the combination of configurations which produces the best integrated image spurs reduction effect (e.g. clock skew reduction) from among the first series of performance tests.

In step S10, other performance tests may be performed, wherein the set configurations are updated between successive tests of the other performance tests so that the combination of set configurations for the N variable elements is different from test to test. The set configuration of each variable element having an identified configuration is its identified configuration from test to test, across those other performance tests. It is understood here that fewer other performance tests are performed than the number of performance tests required for all possible combinations of configurations from the corresponding sets of configurations for the N variable elements to have been tested in method 150. In the above example, this could involve testing combinations [6,0,0,0] to [6,7,7,7], i.e. all combinations where the first variable element has configuration 6. Thus, the second technique involves fewer performance tests than the first technique.

This would then lead to corresponding analysis results, which again may be assumed for example to be integrated image spurs levels obtained as described in connection with the first technique above, i.e. performing a Fast Fourier Transform (FFT) on the output signal in order to assess the group of image spurs at fs/4 + ft, fs/4 - ft, and fs/2 - ft, taking account of aliasing.

In step S12, an analysis result of the performed performance tests (across method 150) which indicates a target performance relative to other analysis results of the performed performance tests is identified. This may be, the performance test with the smallest integrated image spurs level of all the performance tests across method 150. The respective configurations for the N variable elements set for the test corresponding to that identified analysis result are then set in step S14 to be the respective calibrated configurations for the N variable elements. Continuing the above example, it may be that the performance test of the combination [6,4,0,0] gave the smallest integrated image spurs level of all performance tests. Thus, configuration 6 would be set as the calibrated configuration for the first variable element (variable capacitor), 4 for the second, 0 for the third and 0 for the fourth.

The particular implementation 160 of Figure 9B will now be considered. As indicated in Figure 9B, the particular implementation 160 is an example implementation of step S10 of method 150. The particular implementation comprises steps S20 and S22.

It is recalled that in step S10, other performance tests may be performed, wherein the set configurations are updated between successive tests of the other performance tests so that the combination of set configurations for the N variable elements is different from test to test. The implementation 160 enables this to be done by repeating the sequence of steps S4 to S8 but with a different value of X each time, as will become apparent.

In step S22, it is determined whether X is equal to N. If not (S20, NO), the method proceeds to step S22 and the value of X is incremented by 1 and the method proceeds to step S4 with the new value of X. If X does equal N, (S20, YES), the method proceeds to step S12. In this way, it will be appreciated that the sequence of steps S4 to S8 is repeated but with a different value of X each time, and until the sequence of steps S4 to S8 has been carried out for all of the values of X in the range 1≤X≤N (with an optional difference for the repetition when X=N as mentioned later). Of course, incrementing by 1 is just one convenient way of stepping through all of the values of X.

For example, once the value of X has been incremented to X=2, in step S4 an Xth (second) series of performance tests (corresponding to the second clock line) is then carried out as described above, where each performance test comprises setting the configurations of the N variable elements (in this case, variable capacitors) to respective configurations (capacitance values) selected from their respective sets of configurations (capacitance values), operating the clock-controlled circuitry 100 based on the N-phase clock signal with the N variable elements having their respective set configurations for that performance test and with a test input signal (e.g. as configured in the initial step mentioned above) supplied to the signal processing circuitry 106, and analysing the generated output signal (e.g. in the controller 108) to produce a corresponding analysis result.

Again, each analysis result may be stored by the controller 108 in the memory 110, or a running "best" analysis result may be stored. Continuing the above example, where the performance test of the combination [6,0,0,0] gave the smallest integrated image spurs level of the first (X=1) series of performance tests, in the present execution of steps S4 to S8 (when X=2) the Xth series of performance tests may comprise 8 performance tests in which the respective tested combinations are [6,0,0,0], [6,1,0,0], [6,2,0,0], [6,3,0,0], [6,4,0,0], [6,5,0,0], [6,6,0,0] and [6,7,0,0]. These may be considered to be performance tests 9 to 16 (in any order in general, but carried out in the above order in this example), with the corresponding combinations also being considered combinations 9 to 16. Note that in this example (where X=2) the set configuration of the second variable element is different from test to test across those tests and the set configuration of each of the other variable elements of the N variable elements is the same from test to test across those tests.

Note also that, in line with step S10, the set configuration of each variable element having an identified configuration is its identified configuration from test to test across these other performance tests. That is, configuration 6 is used for the first variable element across combinations 9 to 16.

This would then lead to a further 8 analysis results, as before. An example set of analysis results for combinations 9 to 16 are plotted in section 174 of Figure 10.

In step S6 where X=2, an analysis result of the second series of performance tests which indicates a target performance relative to the other analysis results of the second series of performance tests is identified. This may be, where X=2, the performance test with the smallest integrated image spurs level in section 174 of Figure 10.

In step S8 where X=2, the configuration of the second variable element set for the test corresponding to that identified analysis result is then set as the identified configuration for the second variable element. Continuing the above example, it may be that the performance test of the combination [6,4,0,0] gave the smallest integrated image spurs level of the second series of performance tests. Thus, configuration 4 would be set as the identified configuration for the second variable element (variable capacitor).

It will be appreciated that steps S20 and S22 would then increment the value of X to X=3.

Once the value of X has been incremented to X=3, in step S4 an Xth (third) series of performance tests (corresponding to the third clock line) is then carried out following the method 150. Continuing the above example, where the performance test of the combination [6,4,0,0] gave the smallest integrated image spurs level of the second (X=2) series of performance tests, in the present execution of steps S4 to S8 (when X=3) the Xth series of performance tests may comprise 8 performance tests in which the respective tested combinations are [6,4,0,0], [6,4,1,0], [6,4,2,0], [6,4,3,0], [6,4,4,0], [6,4,5,0], [6,4,6,0] and [6,4,7,0]. These may be considered to be performance tests 17 to 24 (in any order in general, but carried out in the above order in this example), with the corresponding combinations also being considered combinations 17 to 24. Note that in this example (where X=3) the set configuration of the third variable element is different from test to test across those tests and the set configuration of each of the other variable elements of the N variable elements is the same from test to test across those tests.

Note also that, in line with step S10, the set configuration of each variable element having an identified configuration is its identified configuration from test to test across these other performance tests. That is, configuration 6 is used for the first variable element, and configuration 4 is used for the second variable element, across combinations 17 to 24.

This would then lead to a further 8 analysis results, as before. An example set of analysis results for combinations 17 to 24 are plotted in section 176 of Figure 10. In step S6 where X=3, an analysis result of the third series of performance tests which indicates a target performance relative to the other analysis results of the third series of performance tests is identified. This may be, where X=3, the performance test with the smallest integrated image spurs level in section 176 of Figure 10.

In step S8 where X=3, the configuration of the third variable element set for the test corresponding to that identified analysis result is then set as the identified configuration for the third variable element. Continuing the above example, it may be that the performance test of the combination [6,4,1,0] gave the smallest integrated image spurs level of the third series of performance tests. Thus, configuration 1 would be set as the identified configuration for the third variable element (variable capacitor).

It will be appreciated that steps S20 and S22 would then increment the value of X to X=4.

Once the value of X has been incremented to X=4, in step S4 an Xth (fourth) series of performance tests (corresponding to the fourth clock line) is then carried out following the method 150. Continuing the above example, where the performance test of the combination [6,4,1,0] gave the smallest integrated image spurs level of the third (X=3) series of performance tests, in the present execution of steps S4 to S8 (when X=4) the Xth series of performance tests may comprise 8 performance tests in which the respective tested combinations are [6,4,1,0], [6,4,1,1], [6,4,1,2], [6,4,1,3], [6,4,1,4], [6,4,1,5], [6,4,1,6] and [6,4,1,7]. These may be considered to be performance tests 25 to 32 (in any order in general, but carried out in the above order in this example), with the corresponding combinations also being considered combinations 25 to 32. Note that in this example (where X=4) the set configuration of the fourth variable element is different from test to test across those tests and the set configuration of each of the other variable elements of the N variable elements is the same from test to test across those tests.

Note also that, in line with step S10, the set configuration of each variable element having an identified configuration is its identified configuration from test to test across these other performance tests. That is, configuration 6 is used for the first variable element, configuration 4 is used for the second variable element, and configuration 1 is used for the third variable element across combinations 25 to 32.

This would then lead to a further 8 analysis results, as before. An example set of analysis results for combinations 25 to 32 are plotted in section 178 of Figure 10. In step S6 where X=4, an analysis result of the fourth series of performance tests which indicates a target performance relative to the other analysis results of the fourth series of performance tests is identified. This may be, where X=4, the performance test with the smallest integrated image spurs level in section 178 of Figure 10.

In step S8 where X=4, the configuration of the fourth variable element set for the test corresponding to that identified analysis result is then set as the identified configuration for the fourth variable element. Continuing the above example, it may be that the performance test of the combination [6,4,1,0] gave the smallest integrated image spurs level of the fourth series of performance tests. Thus, configuration 0 would be set as the identified configuration for the fourth variable element (variable capacitor).

It is noted that in this case, where X=4 (i.e. where X=N and all of the values in the range 1≤X≤N have been used for step S4), it is not necessary to carry out steps S6 and S8 and the method may proceed from step S4 directly to step S10.

It will be appreciated that step S20 would then (S20, YES) would then lead to step S12. In step S12, as before, an analysis result of the performed performance tests (across method 150) which indicates a target performance relative to other analysis results of the performed performance tests is identified. This may be, the performance test with the smallest integrated image spurs level of all the performance tests across method 150 (i.e. across section 172, 174, 176 and 178 of Figure 10). The respective configurations for the N variable elements set for the test corresponding to that identified analysis result are then set in step S14 to be the respective calibrated configurations for the N variable elements. Continuing the above example, it may be that the performance test of the combination [6,4,0,0] gave the smallest integrated image spurs level of all performance tests. Thus, configuration 6 would be set as the calibrated configuration for the first variable element (variable capacitor), 4 for the second, 0 for the third and 0 for the fourth.

In the example illustrated in Figure 10, the minimum integrated image spurs level 180 was measured for combination 13, which corresponds to [6,4,0,0] as above. The uncalibrated integrated image spurs level, for the combination [0,0,0,0], was tested as combination 1 as mentioned above, and thus corresponds to point 181. As with Figure 7, the difference in integrated image spurs levels between points 180 and 181 is around 6.5dB.

In Figure 10 it can be seen that there are three potential minima of the integrated image spur levels at combinations 13 = [6,4,0,0], 18 = [6,4,1,0] and 25= [6,4,1,0]. As it happens, the actual clock lines tested between Figure 7 and Figure 10 were numbered the opposite way around so that, for a more ready comparison with Figure 7 these combinations may be written in reverse as combinations 13 = [0,0,4,6], 18 = [0,1,4,6] and 25= [0,1,4,6]. All of these have the configuration for clock line 1 (phase 1) as configuration 0. This matches with the trend in Figure 7 for the "brute force" method where the integrated image spurs levels go up with the increase of the configuration for clock line 1 from 0 to 7. Also, the potential minima have very small differences in the integrated image spurs levels of less than 0.5dBFS. Different noise environments between repetitions of method 150 with implementation 160 on the same hardware could lead to different ones of these combinations being selected in different repetitions. Note that combinations 18 and 25 which are both equal to [0,1,4,6] are just 1 code different from the optimal combination [0,1,4,7] on Figure 7 (again within the noise margin).

Incidentally, at this juncture it is noted that the method 150 with implementation 160 may be employed with the numbering of clock lines 1 to N applied to actual clock lines in an implementation in any order. As such, if the actual clock lines in an implementation were labelled ABCD (where N=4), they may be dealt with in any order (i.e. any of the 24 permutations of A to D including ABCD and DCBA). That is, the method 150 with implementation 160 is not affected by the order in which real clock lines are numbered.

Step S14 may optionally include storing the calibrated configurations (capacitance values). This can be done in a variety of ways, for example: (a) store the calibrated configurations in non-volatile memory such as programmable read-only memory (PROM), electrically erasable programmable read-only memory (EEPROM), FLASH or E-fuse memory or one-time programmable non-volatile memory (OTP) on the apparatus 100; (b) store values for the calibrated configurations and an associated serial number of the apparatus 100 in a database for publication e.g. on the internet; and (c) print values for the calibrated configurations onto hardware packaging of the apparatus 100.

It will be appreciated from Figure 10, that in method 150 with specific implementation 160 the total number of combinations tested using the second technique is 32 different combinations (8+8+8+8=32), as opposed to testing 4096 combinations as is required by the first technique. This is a factor of 128 (4096/32) saving in the number of performance tests to be carried out, and is a factor of the number of configurations per clock line (here, 8) and phases (here, N=4). For example, with 9 configurations per clock line N=4, the factor saving would be 182.25 (6561/36). The methodology can be used as part of a production test sequence or as part of a power up calibration sequence.

As above, a comparison of Figures 7 and 10 illustrates that substantially the same minimum integrated image spurs level was obtained in both the first and second techniques, giving around 6.5dB improvement over non-calibration combination [0,0,0,0]. As already mentioned, the implementations tested for Figures 7 and 10 were very slightly different in terms of (inevitably) different noise conditions. Thus, it will be immediately apparent that the second technique (method 150) is able to produce a comparable minimum integrated image spurs level by testing fewer combinations that the first technique (significantly so, in the case of implementation 160, i.e. by a factor of 128).

It will be appreciated that in method 150, where implementation 160 is not employed, step S10 may involve a brute force approach (similar to that in the first technique) to an extent, so that after the first series of performance tests have been performed the other performance tests test (some but not all of) the possible combinations of configurations (e.g. capacitance values) which remain untested after the first series of performance tests have been completed. For example, this may be done so that all of the combinations of configurations for the second to fourth variable elements (where N=4) are tested. A similar approach may be taken after the second or third series of performance tests. In these alternative arrangements in which a brute force approach is resumed after completing one or more of the N series of performance tests, the number of combinations tested is reduced compared to using the first technique alone.

**Figure 11** is a schematic diagram useful for understanding how, in the present example where the variable elements are variable capacitors each comprising 7 switchable capacitors, the switching of the capacitors may be implemented.

Two of the N clock lines are shown in Figure 11, arbitrarily labelled as clock lines A and C and thus carrying clock signals CLK-A and CLK-C. In an example where N=4, the clock lines may be labelled A to D for example, with clock lines A and C carrying out-of-phase clock signals for example.

For clock line A, 7 switchable capacitors C1-A to C7-A are shown connected between clock line A and ground via respective "single" switches SW1-A to SW7-A. Collectively these correspond to the variable element for clock line A. Similarly, for clock line C, 7 switchable capacitors C1-C to C7-C are shown connected between clock line A and ground via respective switches "single" SW1-Cto SW7-C. Collectively these correspond to the variable element for clock line C.

One possibility, thus, is to turn on the relevant ones of those "single" switches to configure the variable elements for clock lines A and C for a given performance test. For example, if configuration 3 is desired for clock line A and 5 for clock line C, then switches "single" SW1-A to SW3-A could be turned on for clock line A and "single" switches SW1-C to SW5-C could be turned on for clock line C.

Note, however, that "pair" switches are also provided between corresponding switchable capacitors between clock lines A and C in this example (in another arrangement they could be omitted). For example, "pair" switch SW1-AC connects capacitors C1-A and C1-C in series between clock lines A and C, "pair" switch SW2-AC connects capacitors C2-A and C2-C in series between clock lines A and C, and so on and so forth.

One possibility, thus, is to turn on as many "pair" switches as possible where there is commonality between the number of switchable capacitors to be connected into circuit, and top this up with "single" switches to reach the desired configurations for a given performance test. For example, if configuration 3 is desired for clock line A and 5 for clock line C, then the common number is 3 so "pair" switches SW1-AC to SW3-AC could be turned on for clock lines A to C and "single" switches SW4-C and SW5-C could be turned on for clock line C.

These two approaches (using only "single" switches, or taking into account "pair" switches) may be considered approximately equivalent with the assumption that the midpoint of the "pair" switches acts as a virtual ground. However, if the resistance of the switches (e.g. implemented as FETs such as MOSFETS) is taken into account, e.g. the capacitors C1-A and C1-C see half of the ON state resistance or Ron/2 of their "pair" switch SW1-AC when that switch is used. This may enable more precise and effective trimming of the phase of the clock signals.

The methodology disclosed herein functions both when the clock lines (and thus clock skews) are independent and where the clock lines are organised into pairs (e.g. carrying 180°out-of-phase clock signals) and share some tuning circuitry so that tuning the phase on one clock line of the pair will affect the phase on the other. Incidentally, it is emphasised that the example of 7 switchable capacitors is just an example. For example, the above considerations apply to there being 8 switchable capacitors for each clock line. This results in 9 possible configurations per clock line, and 6561 combinations when N=4 for the brute force approach (and 36 performance tests for method 150 with implementation 160).

**Figure 12** is a schematic diagram of a system 200 useful for understanding that apparatus 100 may be expanded to determine calibration configurations for two sets of clock-controlled circuitry (at the same time). Similar reference signs have been used between Figures 12 and 6 to indicate correspondence between the system 200 and apparatus 100.

In system 200, a first signal generator 102-1 is connected to apply a digital input signal to first signal processing circuity 106-1, which acts as a digital-to-analogue converter (DAC) and outputs an analogue output signal. The first signal generator 102-1 and first signal processing circuity 106-1 may be collectively considered to be a second signal generator 106-2, connected (when a switch 202 is closed) to apply the analogue output signal as an analogue input signal to second signal processing circuity 106-2, which acts as an analogue-to-digital converter (ADC) and outputs a digital output signal. When switch 202 is open, the DAC and ADC may operate as independent converters, the switch 202 being closed for the present calibration.

The digital output signal is provided to a controller 108, which corresponds to the controller 108 of apparatus 100 and acts as the overall controller for system 200. It is assumed that a corresponding memory 110 (not shown) is also provided in system 200. It is assumed that clock generators 104-1 and 104-2 (not shown) are also provided in system 200 to provide corresponding multiphase clock signals CLOCK 1 and CLOCK 2 to the first and second signal processing circuity 106-1 and 106-2, respectively. Similarly, variable elements 114-1 are provided for the clock lines which carry CLOCK 1, and variable elements 114-2 are provided for the clock lines which carry CLOCK 2. These are shown in simplified form in Figure 12. Effectively, there is first and second clock-controlled circuitry in system, each corresponding at least in part to apparatus 100.

The first or second technique described above may be used to determine calibration configurations for the first and second clock-controlled circuitry, with the performance tests being carried out as combined performance tests so as to determine calibration configurations for the first and second clock-controlled circuitry at the same time (i.e.. without needing more performance tests).

For example, where multiphase clock signals CLOCK 1 and CLOCK 2 have different clock frequencies fc1 and fc2, respectively, then the frequency-domain image spurs in the digital output signal out by the second signal processing circuity 106-2 can be distinguished in terms of which relate to the first signal processing circuity 106-1 (and configurations of the variable elements 114-1) and which relate to the second signal processing circuity 106-2 (and configurations of the variable elements 114-2).

For example, for consistency with the earlier examples using N=4, two sets of image spurs may be created, such as: a first set of image spurs located at (fs1)/4 + ft, (fs1)/4 - ft, and (fs1)/2 - ft; and a second set of image spurs located at (fs2)/4 + ft, (fs2)/4 - ft, and (fs2)/2 - ft. Here, given N=4, fs1=4*fc1 and fs2=4*fc2. It is important that fc1 and fc2 are set so that fs1 and fs2 are slightly different from one another to enable the image spurs related to each to be distinguished. The choice of frequencies may be dependent on the specific implementation, for example the spurs content of an ADC and DAC (i.e. depending on the type of signal processing circuitry 106), the frequency resolution of FFT with windowing function, and an available memory size which is a limiting factor for FFT resolution.

Thus, the considerations in respect of the first and second techniques described above apply here *mutatis mutandis,* except that in each performance test (or possibly in at least one performance test) a combination of configurations is adopted for the variable elements 114-1 and another combination of configurations is adopted for the variable elements 114-2.

The first technique could thus be used to generate two separate graphs equivalent to Figure 7, i.e. one relating to the first signal processing circuity 106-1 (and configurations of the variable elements 114-1) and the other to the second signal processing circuity 106-2 (and configurations of the variable elements 114-2). Similarly, the second technique (including method 150 with or without implementation 160) could be used to generate two separate graphs equivalent to Figure 10, i.e. one relating to the first signal processing circuity 106-1 (and configurations of the variable elements 114-1) and the other to the second signal processing circuity 106-2 (and configurations of the variable elements 114-2).

Effectively, taking method 150 with implementation 160 as an example, the N series of performance tests can be performed on the first clock-controlled circuitry and the second clock-controlled circuitry simultaneously. That is, each of the N series of performance tests are carried out on the first and second clock-controlled circuitry at the same time by testing combinations of configurations for both simultaneously. This simultaneous testing of two clock-controlled circuits (effectively, the ADC and DAC and their clock paths together) therefore reduces test time for both by a factor of two, which is important for production where time is important in terms of cost.

The output signal output from the second clock-controlled circuitry (signal processing circuitry 106-2) is analysed for each performance test performed, and separate databases are created to record the analysis results of the first clock-controlled circuitry and the second clock-controlled circuitry separately.

After determining the calibrated configurations for each circuit, they may be set to effectively calibrate the two clock-controlled circuits (effectively, the ADC and DAC and their clock paths).

It is advantageous to provide ADC and DAC circuitry together on integrated circuitry since they may be connected together as in system 200 using switch 202 to allow the first or second technique to performed for both together as above without needing external test equipment, since e.g. the output signal of the second signal processing circuity 106-2 is a digital signal which can be analysed e.g. on chip. The switch 202 could be provided on chip with the DAC and ADC or as an off-chip discrete component which is part of a bigger system. External equipment (e.g. RF test equipment) which might be needed to analyse an analogue output signal directly might for example be costly. A further advantage is that the resulting calibrated configurations can be stored on a single block of memory, rather than requiring dedicated blocks of memory for the ADC and DAC individually.

**Figure 13** is a schematic diagram of integrated circuitry 300 embodying the present invention. The integrated circuitry 300 comprises the apparatus 100 or system 200 described above. The integrated circuitry 300 could be or be part of an IC chip.

Circuitry of the present invention may be implemented as integrated circuitry, for example on an IC chip such as flip chip. The present invention extends to integrated circuitry and IC chips as mentioned above, circuit boards comprising such IC chips, and communication networks (for example, internet fiber-optic networks and wireless networks) and network equipment of such networks, comprising such circuit boards.

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

The present invention may be embodied in many different ways in the light of the above disclosure, within the spirit and scope of the appended claims.

## Claims

1. A method of performing performance tests to determine calibrated configurations for clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result, the method comprising:
with a variable X having an initial value of 1, where 1≤X≤N:
as a step A, performing an Xth series of performance tests corresponding to the Xth clock line, wherein the set configurations are updated between successive tests of that series of performance tests so that the set configuration of the Xth variable element is different from test to test across those tests and the set configuration of at least one other variable element of the N variable elements is the same from test to test across those tests; and
as a step B, identifying an analysis result of the Xth series of performance tests which indicates a target performance relative to the other analysis results of the Xth series of performance tests, and associating the configuration of the Xth variable element set for the test corresponding to that identified analysis result with the Xth variable element as the identified configuration for the Xth variable element;
performing other performance tests, wherein the set configurations are updated between successive tests of the other performance tests so that the combination of set configurations for the N variable elements is different from test to test, and the set configuration of each variable element having an identified configuration is its identified configuration from test to test, across those other performance tests, and wherein fewer other performance tests are performed than the number of performance tests required for all possible combinations of configurations from the corresponding sets of configurations for the N variable elements to have been tested in said method; and
identifying an analysis result of the performed performance tests which indicates a target performance relative to other analysis results of the performed performance tests, and determining the respective configurations for the N variable elements set for the test corresponding to that identified analysis result to be the respective calibrated configurations for the N variable elements.

2. The method of claim 1, comprising, in performing the other performance tests,:
repeating steps A and B at least once, with the variable X having, for each successive repetition of steps A and B, a value in the range 1≤X≤N for which steps A and B have not yet been performed,
optionally wherein:
said repeating steps A and B at least once comprises repeating steps A and B until steps A and B have been performed for all values of X in the range 1≤X<N;
said repeating steps A and B at least once comprises, after repeating steps A and B until steps A and B have been performed for all values of X in the range 1≤X<N, repeating step A and optionally step B for X=N; and
N>2 or N≥4.

3. The method of claim 1 or 2, wherein:
for each performance of step A, the series of performance tests concerned are performed consecutively; and/or
where step A is performed for different values of X, the plurality of performances of step A are performed consecutively so that the performance tests of those performances of step A are consecutively-performed performance tests; and/or
where step A is performed for different values of X, the performance tests of those performances of step A are the only performed performance tests; and/or
where step A is performed for different values of X, the identifying an analysis result of the performed performance tests which indicates the target performance relative to the other analysis results of the performed performance tests comprises identifying an analysis result of the performance tests performed in the plurality of performances of step A.

4. The method of any of the preceding claims, wherein, for each performance of step A, the Xth series of performance tests concerned comprises a performance test per configuration of the set of configurations corresponding to the Xth variable element concerned.

5. The method of any of the preceding claims, wherein, for each performance of step A, the set configurations are updated between successive tests of the series of performance tests concerned so that the set configuration of each variable element of the N variable elements other than the Xth variable element concerned is the same from test to test across those tests.

6. The method of any of the preceding claims, wherein, for each performance test, the analysis result is a value obtained by summing or integrating one or more given frequency-domain signal components in the output signal.

7. The method of claim 6, wherein, for each performance test:
the test input signal has a dominant frequency ft, the test input signal optionally being a sinusoidal test input signal;
the signal processing circuitry has a sampling frequency fs, optionally defined by fs = N*fc, where fc is the clock frequency of the N clock signals of the N-phase clock signal; and
the given frequency-domain signal components comprise the frequency-domain signal components at the frequencies k*fs/N ± ft, for 1≤k≤N where k is an integer, up to the Nyquist frequency fs/2 and including aliases.

8. The method of claim 6 or 7, wherein said frequency-domain signal components:
are frequency-domain signal powers; and/or
are image spurs; and/or
comprise pairs of image spurs centred in frequency around the frequencies k*fs/N, for 1≤k≤N where k is an integer, up to the Nyquist frequency fs/2 and including aliases.

9. The method of any of claims 6 to 8, wherein:
for each performance of step A, the analysis result of the Xth series of performance tests concerned which indicates the target performance relative to the other analysis results of the Xth series of performance tests is the one of those analysis results which has the smallest sum of signal components or result of integrating signal components; and/or
the analysis result of the performed performance tests which indicates the target performance relative to the other analysis results of the performed performance tests is the one of those analysis results which has the smallest sum of signal components or result of integrating signal components.

10. The method of any of the preceding claims, wherein, for each performance test, the analysis result is or comprises an ENOB or SNDR bandwidth of the signal processing circuitry.

11. The method of any of the preceding claims, wherein:
the N variable elements are variable impedances and, for each variable impedance, the configurations of the set of configurations cause that variable impedance to have respective impedance values; or
the N variable elements are configured to vary the lengths of their respective clock lines, wherein, for each variable element, the configurations of the set of configurations cause the clock line concerned to have respective clock line lengths;
the N variable impedances are variable capacitors each comprising a plurality of component capacitors, the method comprising, for at least one performance test, connecting component capacitors of a pair of said clock lines together in series between those clock lines.

12. A method of calibrating clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, the method comprising:
carrying out the method of any of the preceding claims on said clock-controlled circuitry; and
setting the configurations of the N variable elements to their respective calibrated configurations.

13. Apparatus for performing performance tests to determine calibrated configurations for clock-controlled circuitry, the clock-controlled circuitry comprising: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1, and wherein each performance test comprises setting the configurations of the N variable elements to respective configurations selected from their respective sets of configurations, operating the clock-controlled circuitry based on the N-phase clock signal with the N variable elements having their respective set configurations for that performance test and with a test input signal supplied to the signal processing circuitry, and analysing the generated output signal to produce a corresponding analysis result, the apparatus configured to control the clock-controlled circuitry to carry out the method of any of claims 1 to 11.

14. Integrated circuitry comprising the apparatus of claim 13.

15. A method of performing performance tests to determine calibrated configurations for first and second clock-controlled circuitry, wherein:
each of the first and second clock-controlled circuitry comprises: signal processing circuitry configured to generate an output signal based on an input signal and first to Nth clock signals of an N-phase clock signal; and first to Nth clock lines for distributing the respective N clock signals to the signal processing circuitry, the clock lines connected to respective first to Nth variable elements, and each variable element controllable to configure it into a selected one of a corresponding set of configurations which affect a property of the clock line concerned, where N is an integer and where N>1;
each performance test comprises setting the configurations of the N variable elements of the clock-controlled circuitry concerned to respective configurations selected from their respective sets of configurations, operating the clock-controlled circuitry concerned based on the N-phase clock signal with the N variable elements having their respective set configurations for that performance test and with a test input signal supplied to the signal processing circuitry, and analysing the generated output signal to produce a corresponding analysis result;
for the first clock-controlled circuitry, the input signal is a digital input signal, the signal processing circuitry is configured to perform digital-to-analogue conversion, and the output signal is an analogue output signal; and
for the second clock-controlled circuitry, the input signal is an analogue input signal, the signal processing circuitry is configured to perform analogue-to-digital conversion, and the output signal is a digital output signal,
the method comprising:
controlling the N clock signals of the N-phase clock signal for the first clock-controlled circuitry to have a clock frequency fc1 and the N clock signals of the N-phase clock signal for the second clock-controlled circuitry to have a clock frequency fc2, where fc1≠fc2, so that sampling rates of the first and second clock-controlled circuitry are different;
performing the performance tests for the first and second clock-controlled circuitry with at least one pair of performance tests, which performance tests correspond respectively to the first and second clock-controlled circuitry, performed as a combined performance test with the first and second clock-controlled circuitry connected together so that:
the analogue input signal of the second clock-controlled circuitry is or is derived from the analogue output signal of the first clock-controlled circuitry; and
the analysing in respect of the first and second clock-controlled circuitry is carried out on the digital output signal of the second clock-controlled circuitry;
performing the performance tests for the first and second clock-controlled circuitry with, for each of the first and second clock-controlled circuitry, the set configurations updated between successive combined performance tests so that the combination of set configurations for its N variable elements is different from test to test; and
for each of the first and second clock-controlled circuitry, identifying an analysis result of the performed performance tests which indicates a better performance than the other analysis results of the performed performance tests, and determining the respective configurations for the N variable elements set for the test corresponding to that identified analysis result to be the respective calibrated configurations for the N variable elements.
